# EUROPÄISCHE PATENTSCHRIFT

(11) **EP 2 544 915 B1**
(45) Veröffentlichungstag und Bekanntmachung des Hinweises auf die Patenterteilung: **21.01.2015**
(21) Anmeldenummer: 11706258.8
(22) Anmeldetag: 03.03.2011
(51) Int. Cl.: B60K 37/06, B60K 35/00, G06F 3/01, G06F 3/048, G06F 3/033, H03K 17/96

(54) **BEDIENVORRICHTUNG ZUR EINGABE VON STEUERBEFEHLEN IN EIN ELEKTRONISCHES GERÄT**
CONTROL DEVICE FOR ENTERING CONTROL COMMANDS INTO AN ELECTRONIC DEVICE
DISPOSITIF DE COMMANDE SERVANT À ENTRER DES INSTRUCTIONS DE COMMANDE DANS UN APPAREIL ÉLECTRONIQUE

(30) Priorität: 09.03.2010 DE 102010010806
(43) Veröffentlichungstag der Anmeldung: 16.01.2013
(73) Patentinhaber: Continental Automotive GmbH, 30165 Hannover (DE)
(72) Erfinder: LEUCHTENBERG, Bettina, 35630 Ehringshausen (DE); WILDNER, Steffen, 64807 Dieburg (DE)
(86) Internationale Anmeldenummer: PCT/EP2011/053194
(87) Internationale Veröffentlichungsnummer: WO 2011/110470

(56) Entgegenhaltungen:
- DE-A1-102008 009 954
- US-A1- 2008 309 589
- US-A1- 2009 072 662

## Beschreibung

Die Erfindung betrifft eine Bedienvorrichtung zur Eingabe von Steuerbefehlen in ein elektronisches Gerät, wobei die Bedienvorrichtung einen Touchscreen aufweist. Derartige Geräte sind in einer Vielzahl von Anwendungen bekannt.

Die US 2008/0309589 A1 beschreibt eine Bedienvorrichtung eines elektronischen Gerätes mit einem zweigeteilten Touchscreen, wobei der eine Teil des Touchscreens eine hochauflösende Anzeige aufweist und das zweite Teil Beschriftungen oder Symbole, die hinter einem LCD angebracht sind und so je nach Schaltung des LCDs sichtbar oder unsichtbar sind. Die Bedienung des Gerätes erfolgt durch ein Berühren der Beschriftungen oder Symbole. Die DE 10 2008 009 954 A1 beschreibt ein mobiles Endgerät mit einer Anzeige und einem Touchscreen, wobei die Anzeige hochauflösend ist und der Touchscreen eine grobere Auflösung aufweist. Die US 2009/0072662 A1 beschreibt eine Eingabevorrichtung, bei der haptische Rückmeldungen über piezo-elektrische Antriebe generiert werden.

Aufgabe der Erfindung ist es daher, eine Bedienvorrichtung mit einem Touchscreen anzugeben, der eine einfache Bedienbarkeit aufweist. Diese Aufgabe wird durch ein Touchscreen mit den kennzeichnenden Merkmalen des Patentanspruchs 1 gelöst.

Durch die eingefärbte transparente Abdeckung des Touchscreens wird ein einheitliches Aussehen des Touchscreens und der daneben angeordneten Schalter in Form der transparenten oder semitransparenten Sensoren erreicht. Der Touchscreen und die Bild- und/oder Schriftzeichen sind nur dann wahrnehmbar, wenn sie entsprechend beleuchtet werden. So wird zum einen ein einheitliches Aussehen erreicht. Weiterhin können durch eine entsprechende Beleuchtung bestimmte Bildzeichen und/oder Schriftzeichen besonders hervorgehoben werden, und zwar in dem Fall, in dem sie zur Bedienung auswählbar sind. Funktionen, die im entsprechenden Bedienstatus der Bedienvorrichtung nicht auswählbar sind, können entsprechend unbeleuchtet bleiben, so dass einem entsprechenden Bediener der Bedienvorrichtung nur die tatsächlich vorhandenen Auswahlmöglichkeiten angeboten werden. Weiterhin kann die eingefärbte transparente Abdeckung jede beliebige geometrische Form aufweisen und so optisch gut an die entsprechende Position, beispielsweise im Kraftfahrzeug, angepasst werden. Die Abdeckung kann beispielsweise vollständig plan ausgebildet sein, es ist aber auch zum Beispiel möglich, die Abdeckung derart auszugestalten, dass sie zwei Hauptflächen aufweist, die in einem bestimmten Winkel zueinander stehen.

Dadurch, dass die durchleuchtbaren Bild- und/oder Schriftzeichen in Abhängigkeit des Status der Bedienvorrichtung beleuchtet werden, können bestimmte besonders bevorzugte Bedienfunktionen hervorgehoben werden und so eine Bedienung der Bedienvorrichtung insgesamt vereinfacht werden.

Dadurch, dass die Sensoren als kapazitive Schalter ausgestaltet sind, ist eine besonders preiswerte Lösung der Sensoren realisierbar. Weiterhin sind diese Sensoren unempfindlich hinter der Abdeckung anordnenbar.

Wenn mehrere Sensoren zueinander benachbart angeordnet sind, die einem einzigen Bildzeichen zugeordnet sind, sind auch komplexere Schalter darstellbar. Sind beispielsweise mehrere Sensoren benachbart in einer Reihe angeordnet und sind diese einem einzigen Bildzeichen, beispielsweise dem eines stilisierten Schiebereglers oder sonstigen Längskörpers, zugeordnet, ist ein Schieberegler darstellbar. Sind die mehreren Sensoren beispielsweise kreisförmig angeordnet, kann beispielsweise ein Drehsteller nachgebildet werden. Dann ist entsprechend über den Sensoren ein kreis- oder ringförmiges Bildzeichen vorzusehen. Ein Bediener kann dann durch ein Nachfahren des Kreises beziehungsweise des Ringes die Funktion eines Drehstellers bedienen. Wenn diesen zuletzt genannten Bildzeichen weitere Bildzeichen zugeordnet sind, kann beispielsweise durch Auswahl des entsprechenden weiteren Bildzeichens die Funktion des Bildzeichens mit den mehreren Sensoren bestimmt werden. Dies ist besonders intuitiv für einen Benutzer nachvollziehbar, wenn die weiteren Bildzeichen mit einem einzigen Sensor räumlich dem Bildzeichen mit den mehreren Sensoren zugeordnet sind. Beispielsweise können um ein Bildzeichen, das einen Drehsteller darstellt, mehrere Bildzeichen angeordnet werden, die die Funktion des Drehstellers bestimmen sollen. Beispielweise kann das Bildzeichen mit den mehreren Sensoren einen Drehsteller darstellen, und die darum angeordneten Bildzeichen beispielsweise die Stärke eines Ventilators, die Lautstärke des Navigationssystems, die Lautstärke des Radios und die Vorwahltemperatur der Klimaanlage darstellen.

Wenn bestimmten durchleuchtbaren Bild- und/oder Schriftzeichen bestimmte Menüs zugeordnet sind, die nach einem Berühren des Bereichs der Abdeckung oberhalb des entsprechenden durchleuchtbaren Bild- und/oder Schriftzeichens auf dem Touchscreen darstellbar sind, kann auf einfache Art und Weise in eine menübedienbare Bedienfunktion eingestiegen werden. Beispielsweise kann je einem Bild- und/oder Schriftzeichen jeweils ein Menü für die Fahrzeugnavigation, das Radio, Sitzeinstellungen oder sonstige Bedien- oder Informationsmenüs zugeordnet werden.

Wenn bestimmten durchleuchtbaren Bild- und/oder Schriftzeichen bestimmte Funktionseinstellungen direkt zugeordnet sind, können diese Funktionseinstellungen einfach und ohne mehrfache Betätigung der Bedienvorrichtung eingestellt werden.

Die Erfindung wird nachfolgend anhand der Figuren näher beschrieben. Es zeigen:
- Figur 1: die Aufsicht auf ein besonders bevorzugtes erfindungsgemäßes Ausführungsbeispiel, wenn alle Lichtquellen der Bedienvorrichtung eingeschaltet sind,
- Figur 2: den Schnitt AA aus Figur 1,
- Figur 3: die Aufsicht auf das erfindungsgemäße Ausführungsbeispiel aus Figur 1, wenn die eingefärbte transparente Abdeckung und die durchleuchtbaren Bild- und/oder Schriftzeichen entfernt sind.

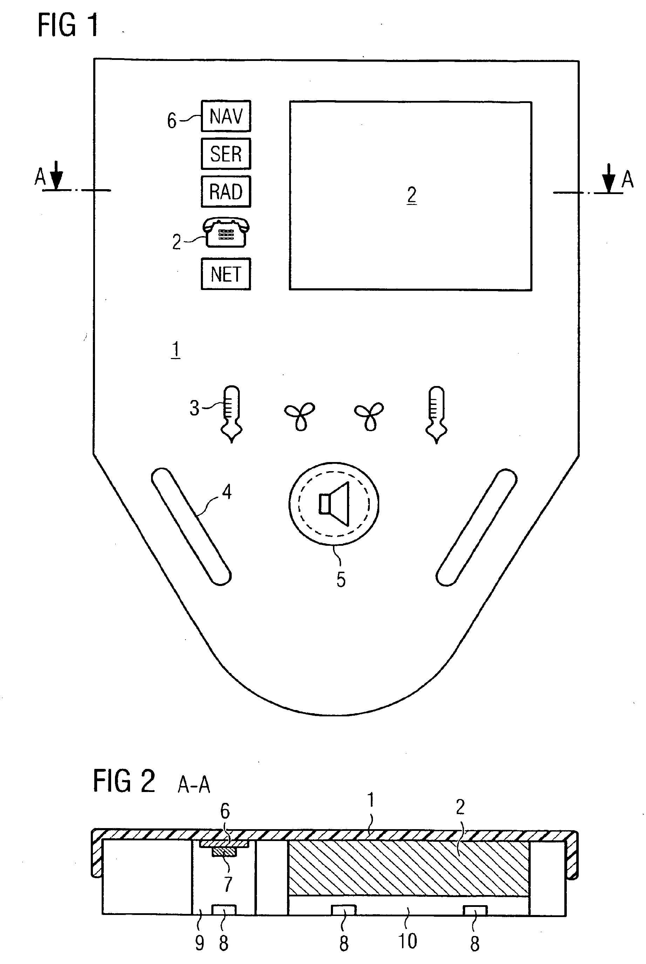

In Figur 1 erkennt man eine eingefärbte transparente Abdeckung 1, durchleuchtbare Bildzeichen 2, 3, 4, 5 und durchleuchtbare Schriftzeichen 6. Der Touchscreen weist vorzugsweise einen Pixelmatrixanzeiger auf und eine Detektionsvorrichtung, die das Vorhandensein eines Eingabeorgans, beispielsweise eines Fingers einer Bedienperson, oberhalb des Touchscreens detektieren kann. Diese Detektion kann beispielsweise induktiv, kapazitiv oder resistiv erfolgen. Besonders bevorzugt ist eine kapazitive Detektion. Die durchleuchtbaren Bildzeichen 2, 3, 4, 5 stellen verschiedene Gegenstände dar. So stellt das Bildzeichen 2 symbolhaft ein Telefon dar, die Bildzeichen 3 symbolhaft ein Thermometer beziehungsweise einen Ventilator, die Bildzeichen 4 einen Schieberegler und das Bildzeichen 5 symbolhaft einen Lautsprecher, der innerhalb eines Kreises dargestellt ist.

Bei dem Schnitt AA in Figur 2 erkennt man die eingefärbte transparente Abdeckung 1, den Touchscreen 2, das durchleuchtbare Schriftzeichen 6, einen transparenten Sensor 7 zur Detektion des Vorhandenseins eines Eingabeorgans, Lichtquellen 8 und Lichtkästen 9, 10. Das durchleuchtbare Schriftzeichen 6 und der transparente Sensor 7 sind höher als in Realität vorhanden dargestellt. Das durchleuchtbare Schriftzeichen 6 kann beispielsweise durch eine Bedruckung der eingefärbten transparenten Abdeckung realisiert sein. Es ist auch möglich, die Position der transparenten Sensoren mit der Position der durchleuchtbaren Schriftzeichen zu vertauschen, wenn die Transparenz der Sensoren derart hoch ist, dass die Wahrnehmbarkeit des durchleuchtbaren Schriftzeichens oder der sonstigen durchleuchtbaren Bildzeichen gewährleistet bleibt. Die Lichtquellen 8 sind innerhalb von Lichtkästen 9 bzw. 10 angeordnet. So beleuchtet die Lichtquelle im Lichtkasten 9 nur das Schriftzeichen 6 und beleuchten die Lichtquellen 8 im Lichtkasten 10 nur den Touchscreen 2. So kann der Bediener auch optisch geführt werden, in dem nur die Eingabemöglichkeiten beleuchtet werden, die direkt bedienbar sind. Beispielsweise ist es möglich, die Bedienvorrichtung derart vorzusehen, dass auf dem Touchscreen 2 zunächst nichts dargestellt wird und auch keine Auswahlmöglichkeiten angeboten werden. Vielmehr kann beispielsweise mittels der Berührung des durchleuchtbaren Bildzeichens 2 oder der durchleuchtbaren Schriftzeichen 6 ein Menü ausgewählt werden. Beispielsweise ist wie in Figur 1 dargestellt, bei der Berührung des obersten durchleuchtbaren Schriftzeichens ein Navigationsmenü, darunterliegend ein Servicemenü, darunterliegend ein Radiomenü, darunterliegend ein Telefonmenü und schließlich darunterliegend ein Internetmenü auswählbar. Wenn das entsprechende Bild- oder Schriftzeichen berührt wurde, wird ein entsprechendes Menü auf dem Touchscreen dargestellt und beispielsweise erst dann der Touchscreen beleuchtet. Der Touchscreen kann selbstverständlich auch durchgängig beleuchtet werden, um sonstige Informationen darzustellen.

Die linken beiden Bildzeichen 3 sind dem linken Bildzeichen 4 zugeordnet, die rechten Bildzeichen 3 dem rechten Bildzeichen 4. Berührt der Bediener beispielsweise das linke Thermometer 3, kann er dann anschließend durch ein Berühren des linken Bildzeichens 4 eine gewünschte Temperatur für die Klimaanlage auf der linken Seite eines Kraftfahrzeuges einstellen. Bei Berühren des symbolhaften linken Ventilators kann entsprechend durch ein Berühren des linken Bildzeichens 4 die Drehzahl eines Ventilators im linken Bereich des Kraftfahrzeuges reguliert werden. Entsprechendes gilt für die Temperatur und den Ventilator auf der rechten Seite des Kraftfahrzeuges durch ein entsprechendes Berühren des rechten Thermometers beziehungsweise Ventilators und Betätigen des rechten Bildzeichens 4. Somit sind die Bildzeichen 3 in diesem Ausführungsbeispiel dem Bildzeichen 4 zugeordnet. Durch ein Berühren des Bildzeichens 5 kann direkt die Lautstärke eines oder mehrerer Lautsprecher im Kraftfahrzeug reguliert werden, ohne dass man sich aufwendig durch Bedienmenüs vorarbeiten muss.

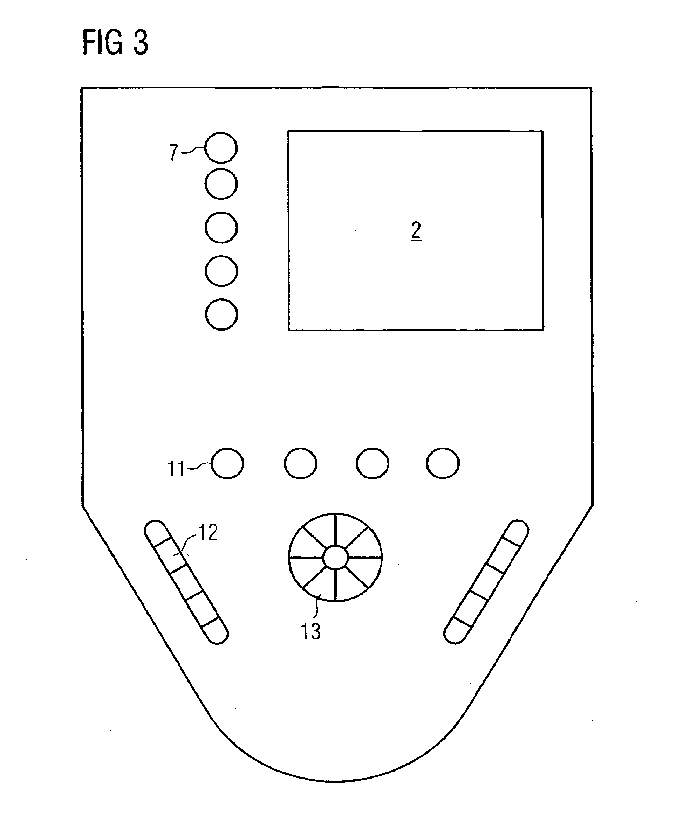

In Figur 3 erkennt man neben dem Touchscreen 2 und den transparenten Sensoren 7 weitere transparente Sensoren 11, 12 und 13, die alle zur Detektion des Vorhandenseins eines Eingabeorgans ausgebildet sind. Die transparenten Sensoren 7 befinden sich unterhalb der Schriftzeichen 6 beziehungsweise des Bildzeichens 2, die Sensoren 11 befinden sich unterhalb der durchleuchtbaren Bildzeichen 3, die Sensoren 12 befinden sich unterhalb der durchleuchtbaren Bildzeichen 4 und die Sensoren 13 befinden sich unterhalb des durchleuchtbaren Bildzeichens 5. Man erkennt, dass jeweils fünf Sensoren 12 zueinander benachbart angeordnet sind. Diese fünf Sensoren 12 sind jeweils einem Bildzeichen 4 aus Figur 1 zugeordnet. So ist es möglich, ein Entlangfahren eines Eingabeorgans eines Bedieners, beispielsweise eines Fingers, entlang des Bildzeichens 4 zu detektieren und so einen Schieberegler nachzubilden. Die Anzahl von fünf benachbarter Sensoren 12 ist nur beispielhaft zu sehen. Wenn noch mehr Sensoren nebeneinander angeordnet werden, kann die Auflösung der Bewegung über den dargestellten Schieberegler weiter erhöht werden. Es ist natürlich auch möglich, weniger Sensoren vorzusehen. Dann wird aber die Auflösung auch entsprechend schlechter. Acht Sensoren 13 sind ringförmig zueinander angeordnet, und zwar unterhalb des Bildzeichens 5 aus Figur 1. So kann durch ein Entlangfahren entlang des Kreises des Bildzeichens 5 mit einem Eingabeorgan ein Drehsteller nachgebildet werden, da die Bewegung des Eingabeorgans auf der Kreisbahn mittels der acht Sensoren 13 detektiert wird. Durch eine entsprechende höhere Anzahl von Sensoren kann die Auflösung auch entsprechend erhöht werden.

Die Funktion des Touchscreens 2 wurde nicht näher beschrieben, da Touchscreens als solche im Stand der Technik hinreichend bekannt sind.

## Patentansprüche

1. Bedienvorrichtung zur Eingabe von Steuerbefehlen in ein elektronisches Gerät, wobei die Bedienvorrichtung einen Touchscreen (2) aufweist und auf dem Touchscreen unterschiedliche Bedienmenüs darstellbar sind,
wobei der Touchscreen (2) hinter einer eingefärbten transparenten Abdeckung (1) angeordnet ist,
wobei hinter der eingefärbten transparenten Abdeckung (1) transparente oder semitransparente Sensoren (7, 11, 12, 13) angeordnet sind, wobei die Sensoren (7, 11, 12, 13) zur Detektion des Vorhandenseins eines Eingabeorgans vor der eingefärbten transparenten Abdeckung (1) ausgebildet sind,
wobei vor den transparenten oder semitransparenten Sensoren (7, 11, 12, 13) durchleuchtbare Bildzeichen (2, 3, 4, 5) und/oder durchleuchtbare Schriftzeichen (6) angeordnet sind, und
wobei Lichtquellen (8) zur Beleuchtung des Touchscreens und der durchleuchtbaren Bild- und/oder Schriftzeichen (2, 3, 4, 5, 6) vorhanden sind, **dadurch gekennzeichnet, dass** die Sensoren (7,11,12,13) neben dem Touchscreen angeordnet sind.

2. Bedienvorrichtung nach Anspruch 1, **dadurch gekennzeichnet, dass** die durchleuchtbaren Bild- und/oder Schriftzeichen (2, 3, 4, 5, 6) in Abhängigkeit des Status der Bedienvorrichtung beleuchtet werden.

3. Bedienvorrichtung nach einem der vorstehenden Ansprüche,
**dadurch gekennzeichnet , dass** die Sensoren (7, 11, 12, 13) als kapazitive Schalter ausgestaltet sind.

4. Bedienvorrichtung nach einem der vorstehenden Ansprüche,
**dadurch gekennzeichnet, dass** mehrere Sensoren (12, 13) zueinander benachbart angeordnet sind, die einem einzigen Bildzeichen (4, 5) zugeordnet sind.

5. Bedienvorrichtung nach Anspruch 4, **dadurch gekennzeichnet, dass** die Funktion des Bildzeichens (4), dem mehrere Sensoren (12) zugeordnet sind, durch weitere Bildzeichen (3) auswählbar ist.

6. Bedienvorrichtung nach Anspruch 5, **dadurch gekennzeichnet, dass** die weiteren Bildzeichen (3) räumlich dem Bildzeichen (4), dem mehrere Sensoren (12) zugeordnet sind, zugeordnet sind.

7. Bedienvorrichtung nach einem der vorstehenden Ansprüche, **dadurch gekennzeichnet, dass** bestimmten durchleuchtbaren Bild- und/oder Schriftzeichen (2, 6) bestimmte Menüs zugeordnet sind, die nach einem Berühren des Bereichs der Abdeckung oberhalb des entsprechenden durchleuchtbaren Bild- und/oder Schriftzeichen (2, 6) auf dem Touchscreen darstellbar sind.

8. Bedienvorrichtung nach einem der vorstehenden Ansprüche, **dadurch gekennzeichnet, dass** bestimmten durchleuchtbaren Bild- und/oder Schriftzeichen (5) bestimmte Funktionseinstellungen direkt zugeordnet sind.

## Claims

1. Control device for entering control commands into an electronic device, wherein the control device comprises a touch screen (2), and various control menus can be displayed on the touch screen,
wherein the touch screen (2) is disposed behind a colored transparent cover (1),
wherein transparent or semitransparent sensors (7, 11, 12, 13) are disposed behind the colored transparent cover (1), wherein the sensors (7, 11, 12, 13) are implemented for detecting the presence of an input organ in front of the colored transparent cover (1),
wherein illuminable symbols (2, 3, 4, 5) and/or illuminable characters (6) are disposed in front of the transparent or semitransparent sensors (7, 11, 12, 13), and wherein light sources (8) for illuminating the touch screen and the illuminable symbols and/or characters (2, 3, 4, 5, 6) are present, **characterized in that** adjacent to the touch screen the sensors (7,11,12,13) are disposed.

2. Control device according to Claim 1, **characterized in that** the illuminable symbols and/or characters (2, 3, 4, 5, 6) are illuminated according to the status of the control device.

3. Control device according to one of the preceding claims, **characterized in that** the sensors (7, 11, 12, 13) are implemented as capacitive switches.

4. Control device according to one of the preceding claims, **characterized in that** multiple sensors (12, 13) are disposed adjacent to one another, and are associated with a single symbol (4, 5).

5. Control device according to Claim 4, **characterized in that** the function of the symbol (4) with which multiple sensors (12) are associated can be selected through further symbols (3).

6. Control device according to Claim 5, **characterized in that** the further symbols (3) are associated spatially with the symbol (4) with which multiple sensors (12) are associated.

7. Control device according to one of the preceding claims, **characterized in that** particular menus are associated with particular illuminable symbols and/or characters (2, 6), and can be displayed on the touch screen after the region of the cover above the corresponding illuminable symbol and/or character (2, 6) has been touched.

8. Control device according to one of the preceding claims, **characterized in that** specific functional settings are assigned directly to particular illuminable symbols and/or characters (5).

## Revendications

1. Dispositif de commande pour entrer des instructions de commande dans un appareil électronique, le dispositif de commande ayant un écran (2) tactile et des menus de commande différents pouvant être représentés sur l'écran tactile,
dans lequel l'écran (2) tactile est disposé derrière un recouvrement (1) transparent coloré,
dans lequel des capteurs (7, 11, 12, 13) transparents ou semi-transparents sont disposés derrière le recouvrement (1) transparent coloré, les capteurs (7, 11, 12, 13) étant constitués pour la détection de la présence d'un organe d'entrée devant le recouvrement (1) transparent coloré, dans lequel des symboles (2, 3, 4, 5) graphiques pouvant être éclairés par transparence et/ou des caractères (6) pouvant être éclairés par transparence sont disposés devant les capteurs (7, 11, 12, 13) transparents ou semi-transparents et
dans lequel il y a des sources (8) lumineuses pour éclairer l'écran tactile et les symboles graphiques et/ou les caractères (2, 3, 4, 5, 6) pouvant être éclairés par transparence,
**caractérisé en ce que** les capteurs (7, 11, 12, 13) sont disposés à côté de l'écran tactile.

2. Dispositif de commande suivant la revendication 1, **caractérisé en ce que** les symboles graphiques et/ou les caractères (2, 3, 4, 5, 6) pouvant être éclairés par transparence sont éclairés en fonction de l'état du dispositif de commande.

3. Dispositif de commande suivant l'une des revendications précédentes, **caractérisé en ce que** les capteurs (7, 11, 12, 13) sont conformés en commutateurs capacitifs.

4. Dispositif de commande suivant l'une des revendications précédentes, **caractérisé en ce que** plusieurs capteurs (12, 13) sont disposés en étant voisins les uns des autres et sont associés à un symbole (4, 5) graphique unique.

5. Dispositif de commande suivant la revendication 4, **caractérisé en ce que** la fonction du caractère (4) graphique, auquel sont associés plusieurs capteurs (12), peut être sélectionnée par d'autres symboles (3) graphiques.

6. Dispositif de commande suivant la revendication 5, **caractérisé en ce que** les autres symboles (3) graphiques sont associés dans l'espace au symbole (4) graphique, auquel sont associés plusieurs capteurs (12).

7. Dispositif de commande suivant l'une des revendications précédentes, **caractérisé en ce qu'**à des symboles graphiques et/ou caractères (2, 6) pouvant être éclairés par transparence sont associés des menus déterminés, qui peuvent, après avoir touché la région du recouvrement, être représentés sur l'écran tactile au dessus des symboles graphiques et/ou caractères (2, 6) correspondants pouvant être éclairés par transparence.

8. Dispositif de commande suivant l'une des revendications précédentes, **caractérisé en ce que** des réglages de fonction déterminés sont associés directement à des symboles graphiques et/ou caractères (5) déterminés pouvant être éclairés par transparence.
